(19) Europäisches Patentamt
European Patent Office
Office européen des brevets

(11) EP 2 936 181 B1

(12) EUROPÄISCHE PATENTSCHRIFT

(45) Veröffentlichungstag und Bekanntmachung des Hinweises auf die Patenterteilung:
22.02.2017 Patentblatt 2017/08

(51) Int Cl.:
*G01R 33/04* (2006.01)      *B06B 1/08* (2006.01)
*G01R 33/12* (2006.01)

(21) Anmeldenummer: 13828904.6

(22) Anmeldetag: 23.12.2013

(86) Internationale Anmeldenummer:
PCT/AT2013/050263

(87) Internationale Veröffentlichungsnummer:
WO 2014/094029 (26.06.2014 Gazette 2014/26)

(54) **VERFAHREN UND VORRICHTUNG ZUR BESTIMMUNG DER MAGNETISCHEN EIGENSCHAFT EINES BLECHPAKETS**

METHOD AND DEVICE FOR DETERMINING THE MAGNETIC CHARACTERISTICS OF A LAMINATION STACK

PROCÉDÉ ET DISPOSITIF DE DÉTERMINATION DE LA CARACTÉRISTIQUE MAGNÉTIQUE D'UN PAQUET DE TÔLES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.12.2012 AT 506202012**

(43) Veröffentlichungstag der Anmeldung:
**28.10.2015 Patentblatt 2015/44**

(73) Patentinhaber: **voestalpine Stahl GmbH 4020 Linz (AT)**

(72) Erfinder:
• **BORZ, Markus**
**A-4611 Buchkirchen (AT)**
• **FÜREDER-KITZMÜLLER, Friedrich**
**A-4048 Puchenau (AT)**
• **HASLMAYR, Michael**
**A-4048 Puchenau (AT)**
• **SCHUSTER, Stefan**
**A-4470 Enns (AT)**

(74) Vertreter: **Jell, Friedrich**
**Bismarckstrasse 9**
**4020 Linz (AT)**

(56) Entgegenhaltungen:
WO-A1-2011/012159      JP-A- H06 194 436
JP-A- H08 278 358      JP-A- H11 101 863
JP-A- 2006 090 825

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 936 181 B1

**Beschreibung**

Technisches Gebiet

Die Erfindung betrifft ein Verfahren und eine Vorrichtung zur Bestimmung der magnetischen Eigenschaft eines Blechpakets mit einem ferromagnetischen Kern, mit einer Erregereinrichtung, die eine Leistungsversorgung und einen von der Leistungsversorgung angeregten elektrischen Schwingkreis aufweist, der eine Kapazität und eine mit der Kapazität elektrisch verbundene, am Kern vorgesehene Erregerwicklung umfasst, welche Erregerwicklung einen magnetischen Fluss im Kern für einen magnetischen Kreis erzeugt, und mit einer Messeinrichtung, die eine am Kern vorgesehene, mit der Erregerwicklung magnetisch gekoppelte Messwicklung aufweist.

Stand der Technik

Um die magnetische Eigenschaft eines Blechpakets zu bestimmen bzw. zu messen, ist es aus dem Stand der Technik bekannt (AT391522B), mit einer auf einem u-förmigen Joch bzw. auf einem Kern befestigten Erregerspule einen elektromagnetischen Fluss zu erzeugen, der sich über das Blechpaket zu einem magnetischen Kreis schließt. Die Erregerspule wird dabei durch eine Wechselspannungsquelle angespeist. Durch eine mit der Erregerspule magnetisch gekoppelte Messspule, die am Kern ebenso befestigt ist, kann nun auf die magnetische Eigenschaft des Blechpakets rückgeschlossen werden. Sollen mit diesem Verfahren bzw. dieser Vorrichtung Hystereseverluste gemessen werden, zeigte sich nachteilig ein vergleichsweise hoher elektrischer Verlustfaktor in der Leistungsversorgung der Vorrichtung, um die Grenzen der Hysteresekurve erfassen zu können. Dies umso mehr, wenn es gilt, Blechpakete für leistungsstarke elektrische Maschinen in Bezug auf ihre magnetischen Eigenschaften zu messen.

Des Weiteren ist es bei Wirbelstromsensoren bekannt (DE1773501A), der Erregerspule einen Kondensator parallel zu schalten, um damit der Erregereinrichtung eine andere Resonanzcharakteristik als der Messeinrichtung zu geben. Die Resonanzfrequenz des Schwingkreises aus Erregerwicklung und Kondensator unterscheidet sich von der Anregungsfrequenz des Oszillators, der den Schwingkreis als Leistungsversorgung zu einer erzwungenen Schwingung anregt. Nachteilig führt auch diese Vorrichtung zu einem vergleichsweise hohen elektrischen Verlustfaktor in ihrer Leistungsversorgung. Zudem sind Wirbelstromsensoren zur Messung von Hystereseverlusten nicht geeignet.

Weitere relevante Veröffentlichungen sind: JPH11101863 , JPH06194436, JPH08278358, WO2011/012159 und JP2006090825.

Darstellung der Erfindung

Die Erfindung hat sich daher die Aufgabe gestellt, eine Vorrichtung der eingangs geschilderten Art derart auf konstruktiv einfache Weise zu verändern, dass mit dieser energieeffizient selbst Blechpakte, die zur Aufnahme vergleichsweise hoher magnetischer Flussdichten geeignet sind, auf deren magnetischen Eigenschaft, insbesondere hinsichtlich magnetischer Verluste, gemessen werden können.

Die Erfindung löst die gestellte Aufgabe dadurch, dass die Leistungsversorgung den Schwingkreis zu einer Schwingung mit der Resonanzfrequenz des Schwingkreises anregt.

Regt die Leistungsversorgung den Schwingkreis zu einer Schwingung mit der Resonanzfrequenz des Schwingkreises an, können selbst Blechpakete mit hoher Sättigungsauslegung äußerst energieeffizient auch hinsichtlich ihrer Hystereseverluste gemessen werden. Abgesehen von ohmschen Wirkleistungsverlusten kann nämlich die für einen vergleichsweise hohen magnetischen Fluss im Blechpaket erforderliche Energie zum Treiben der Erregerspule in der Erregereinrichtung gehalten bzw.

im Kondensator zwischengespeichert werden. Erfindungsgemäß können so die positiven und negativen Sättigungswerte der Hysteresekurve bzw. -schleife mit vergleichsweise geringer Gesamtblindleistung mehrmals über die Messwicklung gemessen werden. Die Vorrichtung kann sich daher in ihrem vergleichsweise kostengünstigen Betrieb auszeichnen. Zudem kann auf zusätzliche Maßnahme zur Blindstromkompensation verzichtet werden, was für eine weitere Kostenreduktion der Vorrichtung genutzt werden kann.

Im Allgemeinen wird erwähnt, dass das Blechpaket einen Stator, Rotor oder auch eine andere elektrische Komponente einer elektrischen Maschine darstellen kann. Unter Blechpaket können isolierend verbundene Blechteile bzw. Elektrobleche verstanden werden. Beispielsweise kann sich Backlack zur Verbindung der Blechteile zu einem Blechpaket eignen. Zudem wird im Allgemeinen erwähnt, dass unter magnetische Eigenschaft eines Blechpakets die magnetischen Verluste des Blechpakets insbesondere verstanden werden können, die sich aus Wirbelstromverlusten und/oder Hystereseverlusten zusammensetzen können.

Besonders energieeffizient kann die Messung am Blechpaket vorgenommen werden, wenn die Leistungsversorgung den Schwingkreis zu einer freien Schwingung anregt. Nach einem Aufladen des Schwingkreises durch die Leistungsversorgung muss der Erregereinrichtung somit nämlich keine weitere elektrische Energie zugeführt werden, sodass eine autarke Messung der magnetischen Eigenschaften möglich ist. Dies kann unter anderem zu einer hinsichtlich Störungen besonders standfesten Messung führen. Vorteilhaft kann der Schwingkreis zu einer freien Schwingung während der gesamten Messdatenerfassung angeregt werden.

Regt die Leistungsversorgung den Schwingkreis zu einer erzwungenen Schwingung an, kann durch wiederholte Messungen bei maximaler Spannungsamplitude der Erregerschwingung zur Erzeugung des magnetischen Flusses die Genauigkeit des Messverfahrens weiter erhöht werden. Die Vorrichtung kann dadurch äußerst reproduzierbar die magnetische Eigenschaft eines Blechpakets messen. Zudem kann sich mit diesen wiederholten Messungen mit einer Resonanzschwingung an der Erregerspule die Möglichkeit eröffnen, unter Verwendung einer Fehlerrechnung, beispielsweise Standardabweichung, die Genauigkeit der Messdaten noch weiter zu erhöhen. Vorteilhaft kann der Schwingkreis zu einer erzwungenen Schwingung während der gesamten Messdatenerfassung angeregt werden.

Besonders energieeffizient kann die Messung am Blechpaket vorgenommen werden, wenn die Leistungsversorgung den Schwingkreis zu einer zeitweise freien und zeitweise erzwungenen Schwingung anregt. Nach einem Aufladen des Schwingkreises, beispielsweise in Folge der erzwungenen Schwingung, durch die Leistungsversorgung muss der Erregereinrichtung somit nämlich keine weitere elektrische Energie zugeführt werden, sodass eine autarke Messung der magnetischen Eigenschaften möglich ist. Dies kann unter anderem zu einer hinsichtlich Störungen besonders standfesten Messung führen. Vorteilhaft kann der Schwingkreis zu solch einer gemischten Schwingung (erzwungenen und freien Schwingung) während der gesamten Messdatenerfassung angeregt werden.

Die Amplitude der Schwingung zur Erzeugung des elektromagnetischen Flusses kann während der Messung selbst bei Wirkverlusten im Schwingkreis maximal gehalten werden, indem die Anregungsfrequenz der Leistungsversorgung mit der Resonanzfrequenz des Schwingkreises übereinstimmt. Die als Wirkleistung verbrauchte elektrische Energie des Schwingkreises kann nämlich von der Leistungsversorgung ersetzt werden.

Für eine vergleichsweise robuste und energieeffiziente Vorrichtung kann die Leistungsversorgung einen Wechselrichter aufweisen, der mit dem Schwingkreis der Erregereinrichtung einen Schwingkreiswechselrichter ausbildet. Zudem können damit die Herstellkosten der Vorrichtung erheblich reduziert werden. Eine kostengünstige Vorrichtung kann damit geschaffen werden.

Eine zuverlässige Messdatenerfassung kann sich ergeben, wenn der Wechselrichter eine Spannung in den Schwingkreis einprägt.

Die Energieeffizienz der Vorrichtung kann noch weiter erhöht werden, wenn der Schwingkreiswechselrichter eine Schalteinrichtung aufweist, die den Wechselrichter resonant schaltet. Dieses resonante Schalten, also das Nullspannungs- oder Stromschalten, kann nämlich die Resonanzschwingung des Schwingkreises noch weiter anregen und einen erhöhten magnetischen Fluss ohne zusätzliche Energieversorgung für die Erregereinrichtung erzeugen.

Konstruktive Einfachheit kann erreicht werden, wenn der Schwingkreis als Serienschwingkreis ausgebildet ist.

Zur Signalverbesserung der vom Schwingkreis gemessenen elektrischen Größen, kann der Schwingkreis eine Drossel aufweist.

Weist der Schwingkreis zur Veränderung dessen Resonanzfrequenz $f_{res}$ mindestens eine in der Größe veränderbare Kapazität auf, kann ein erhöhtes Leistungsspektrum des Blechpakets hinsichtlich magnetischer Verluste ausgemessen werden. Eine Bandbreite der Resonanzfrequenz von 50Hz bis 10kHz kann sich hier als vorteilhaft herausstellen. Mit einer niedrigen Resonanzfrequenz können beispielsweise Hystereseverluste vorwiegend erfasst werden, wozu sich höhere Resonanzfrequenzen zur Erfassung der Wirbelstromverluste eignen können.

Konstruktiv einfach gelöst kann der Schwingkreis ein über einen Schalter zu- und wegschaltbares Kapazitätselement aufweisen, um damit dessen Resonanzfrequenz $f_{res}$ zu verändern. Es braucht nicht weiter im Allgemeinen erwähnt werden, dass Kapazitätselemente beispielsweise Kondensatoren darstellen können.

Die Erfindung hat sich außerdem die Aufgabe gestellt, ein Verfahren zur Bestimmung der magnetischen Eigenschaft, insbesondere hinsichtlich der magnetischen Verluste, eines Blechpakets zu schaffen, das äußerst energieeffizient ist.

Die Erfindung löst die gestellte Aufgabe dadurch, dass der Schwingkreis zur Erzeugung des elektromagnetischen Flusses zu einer Schwingung mit seiner Resonanzfrequenz angeregt wird.

Wird der Schwingkreis zur Erzeugung des elektromagnetischen Flusses zu einer Schwingung mit seiner Resonanzfrequenz angeregt, kann ein besonders energieeffizientes Verfahren ermöglicht werden, die Sättigungswerte eines Blechpakets zu bestimmen, um damit die magnetischen Verluste, vorzugsweise Hystereseverluste, und infolgedessen die maximalen Verluste zu bestimmen.

Einfache Verfahrensverhältnisse ergeben sich, indem der Schwingkreis zu einer freien Schwingung angeregt wird. Es kann nämlich durchaus ausreichen, ein freies Ausschwingverhalten des Schwingkreises für eine ausreichende Messdatenerfassung zu nutzen. Vorteilhaft kann der Schwingkreis zu einer freien Schwingung während der gesamten Messdatenerfassung angeregt werden.

Die Genauigkeit der Messdatenerfassung zur Bestimmung von Sättigungswerten des Blechpakets kann erhöht werden, indem der Schwingkreis zu einer erzwungenen Schwingung anregt wird. Durch die erhöhte Anzahl an wiederholt messtechnisch erfassten gleichen Schwingungen kann sich nämlich die Option eröffnen, Verfahren zur Fehlerkorrektur zu verwenden, um die Genauigkeit des Verfahrens weiter zu erhöhen. Vorteilhaft kann der Schwingkreis zu solch einer gemischten Schwingung (erzwungenen und freien Schwingung) während der gesamten Messdatenerfassung angeregt werden.

Einfache und dennoch energieeffiziente Verfahrensverhältnisse ergeben sich, indem der Schwingkreis zu einer zeitweise freien und zeitweise erzwungenen Schwingung angeregt wird. Anhand der Messdaten zur freien Schwingung kann beispielsweise ein freies Ausschwingverhalten des Schwingkreises gemessen, was für eine hohe Genauigkeit in der Bestimmung der magnetischen Verluste beitragen kann. Vorteilhaft kann der Schwingkreis zu einer erzwungenen und freien Schwingung während der gesamten Messdatenerfassung angeregt werden.

Das Verfahren kann hinsichtlich seiner Genauigkeit in der Bestimmung von Sättigungswerten des Blechpakets weiter verbessert werden, indem die Anregungsfrequenz und die Resonanzfrequenz des Schwingkreises gleich sind. Auf diese Weise kann nämlich ermöglicht werden, eine erhöhte Anzahl an redundanten Messdaten zur Bestimmung der magnetischen Eigenschaft des Blechpakets zur Verfügung zu stellen.

Wird für die Bestimmung der magnetischen Eigenschaft des Blechpakets die Resonanzfrequenz des Schwingkreises verändert, kann ein erhöhtes Leistungsspektrum des Blechpakets hinsichtlich der magnetischen Verluste ausgemessen werden. Eine Bandbreite der Resonanzfrequenz von 50Hz bis 10kHz kann sich hier als vorteilhaft herausstellen. Mit einer niedrigen Resonanzfrequenz können beispielsweise Hystereseverluste vorwiegend erfasst werden, wozu sich höhere Resonanzfrequenzen zur Erfassung der Wirbelstromverluste eignen können.

Vereinfachte Handhabungsverhältnisse am Verfahren können sich ergeben, die Größe der Kapazität verändert wird. Diese Veränderung kann beispielsweise durch ein Verändern der Größe der elektrischen Kapazität im Schwingkreis erfolgen, indem Kapazitäten über Schalter dem Schwingkreis zu- oder weggeschaltet werden.

Bei der Bestimmung der magnetischen Eigenschaft des Blechpakets kann zwischen Wirbelstromverlusten und Hystereseverlusten unterschieden werden, in dem der Schwingkreis nacheinander mit zwei unterschiedlichen Resonanzfrequenzen betrieben wird. Eine Bandbreite der Resonanzfrequenz von 50Hz bis 10kHz kann sich hier als vorteilhaft herausstellen. Mit einer niedrigen Resonanzfrequenz können beispielsweise Hystereseverluste vorwiegend erfasst werden, wozu sich höhere Resonanzfrequenzen zur Erfassung der Wirbelstromverluste eignen können.

Das Verfahren kann verbessert werden, wenn basierend auf den aufgenommenen Messdaten ein mathematisches Modell der Hysteresekurve bestimmt wird, die bei der Bestimmung der magnetischen Eigenschaft des Blechpakets berücksichtigt wird. Die Fläche der Hysteresekurve kann nämlich ein Maß für die magnetischen Verluste darstellen. Zur Bestimmung eines mathematischen Modells der Hysteresekurve können verschiedenste Verfahren verwendet werden. Beispielsweise kann hierzu eine Langevin-Funktion dienen, um die Hysterese mathematisch mit einem parametrischen Modell zu beschreiben. Die Parameter für diese Funktion können aus den aktuellen Messdaten bestimmt bzw. daraus geschätzt werden. Andere Funktionen sind im Allgemeinen vorstellbar.

Wird im mathematischen Modell der Luftspalt als Scherung der Hysteresekurve berücksichtigt, kann sich das Verfahren in der Genauigkeit verbessern. Für kleine Luftspalte kann man nämlich in guter Näherung annehmen, dass der Luftspalt die Hysteresekurve mit einer Geraden schert. Wird der Luftspalt in dieser Betrachtung im mathematischen Modell berücksichtigt, kann zwischen Einfluss des Luftspalts und Einfluss des Blechpakets unterscheiden werden.

Die Genauigkeit des Verfahrens kann sich noch weiter erhöhen, wenn bei der Bestimmung der magnetischen Eigenschaften des Blechpakets ein Vergleich zwischen Referenzmessdaten an einem Referenzblechpaket mit den aufgenommenen Messdaten eingeht. Hierzu kann eine Messbrücke vorteilhaft verwendet werden.

Kurze Beschreibung der Zeichnung

In den Figuren ist beispielsweise der Erfindungsgegenstand anhand von Ausführungsbeispielen näher dargestellt. Es zeigen

Fig. 1     eine schematische Ansicht auf eine erfindungsgemäße Vorrichtung zur Messung einer magnetischen Eigenschaft eines Blechpakets nach einem ersten Ausführungsbeispiel,

Fig. 2     eine schematische Ansicht auf eine zur Fig. 1 alternative Erregereinrichtung nach einem zweiten Ausführungsbeispiel,

Fig. 3     der Schwingkreis der Fig. 2 mit einer Detailansicht zur Kapazität,

Fig. 4     einen Signalverlauf zu einer freien Schwingung,

Fig. 5     einen Signalverlauf zu einer erzwungenen Schwingung,

Fig. 6     einen Signalverlauf zu einer zeitweise freien und zeitweise erzwungenen Schwingung und

Fig. 7     eine schematische Ansicht auf eine zur Fig. 1 alternative weitere Erregereinrichtung nach einem dritten Ausführungsbeispiel.

Weg zur Ausführung der Erfindung

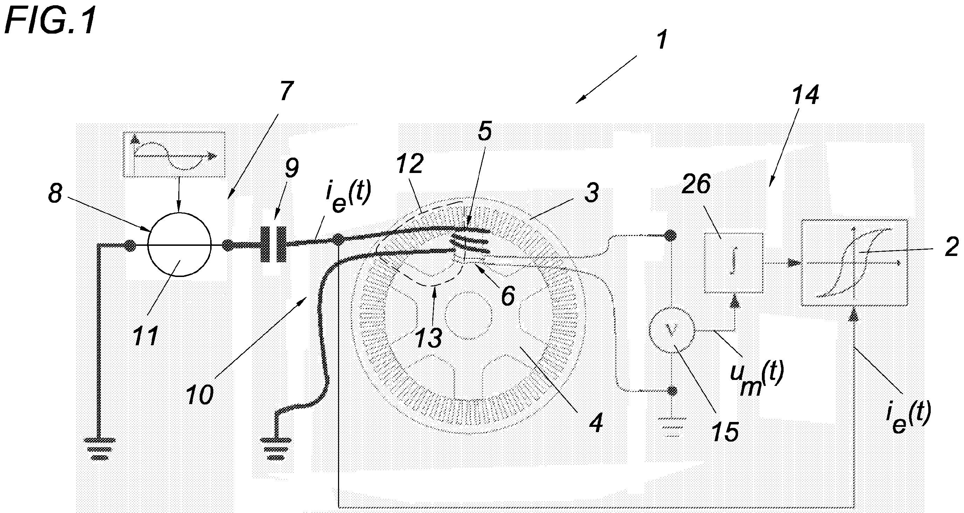

Die in Figur 1 nach einem ersten Ausführungsbeispiel dargestellte Vorrichtung 1 zur Messung von magnetischen Verlusten, beispielsweise unter Verwendung der Hysteresekurve 2, eines Blechpakets 3 weist einen ferromagnetischen Kern 4 auf. Um diesen Kern 4 sind zwei Wicklungen vorgesehen, nämlich eine Erregerwicklung 5 und eine Messwicklung 6, die magnetisch gekoppelt sind. Die Erregerwicklung 5 ist Teil einer Erregereinrichtung 7, die eine Leistungsversorgung 8 und eine Kapazität 9 mitumfasst. Erregereinrichtung 7 und Kapazität 9 sind zu einem Serienschwingkreis 10 elektrisch verschaltet. Diese Kapazität 9 kann beispielsweise durch ein oder mehrere zusammengeschaltete Kapazitätselemente, beispielsweise Kondensator bzw. Kondensatoren, ausgebildet werden.

Die elektrische Leistungsversorgung 8 ist nach Fig. 1 als eine über eine Steuerspannung regelbare Stromquelle 11 dargestellt und erzeugt im Schwingkreis 10 einen Strom $i_e(t)$, wodurch die Erregerwicklung 5 einen magnetischen Fluss 12 im Kern 4 erzeugt, der zu einem magnetischen Kreis 13 führt. In diesem magnetischen Kreis 13 liegen das Blechpaket 3, der Kern 4 und die sich zwischen Kern 4 und Blechpaket 3 ergebenden Luftspalte. Der magnetische Kreis 13 führt daher über das Blechpaket 3.

Die Messwicklung 6 ist Teil einer Messeinrichtung 14, die magnetisch mit der Erregerwicklung 5 gekoppelt ist. Vorzugsweise weisen Erregereinrichtung 7 und Messwicklung 6 unterschiedliche Windungszahl auf. Von der als Spule ausgeführten Messwicklung 6 wird die Messspannung $u_m(t)$ über ein Spannungsmessgerät 15 abgegriffen, welche Spannung $u_m(t)$ bei der Bestimmung der magnetischen Eigenschaft des Blechpakets 3 berücksichtigt wird. Um nun hohe Flussdichten im Blechpaket 3 erzeugen und dabei trotzdem eine besonders hohe Energieeffizienz erreichen zu können, wird der Schwingkreis 10 von der Leistungsversorgung 8 mit der Resonanzfrequenz $f_{res}$ des Schwingkreises 10 angeregt.

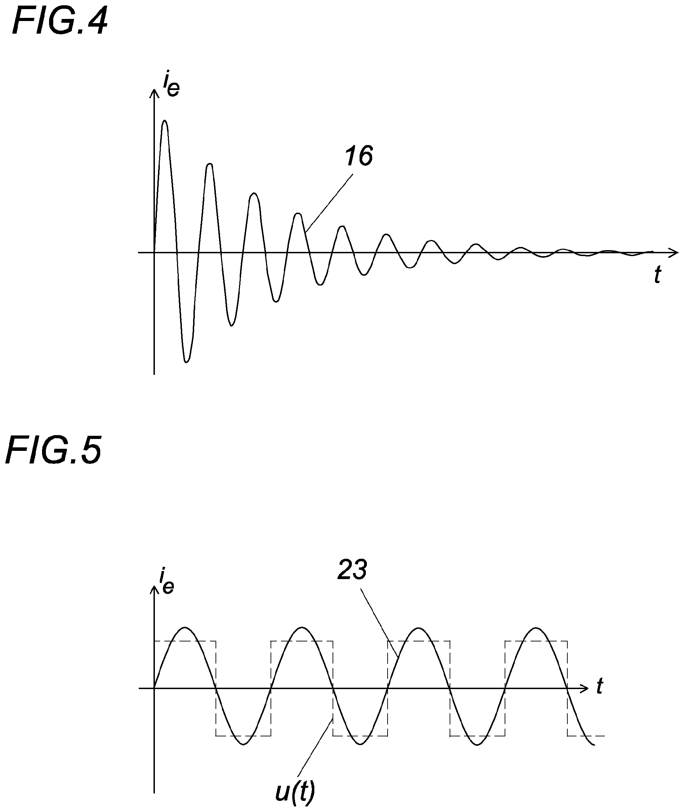

Der Schwingkreises 10 kann, wie in den Figuren 4, 5 und 6 dargestellt, unterschiedlich mit der Resonanzfrequenz $f_{res}$ schwingen.

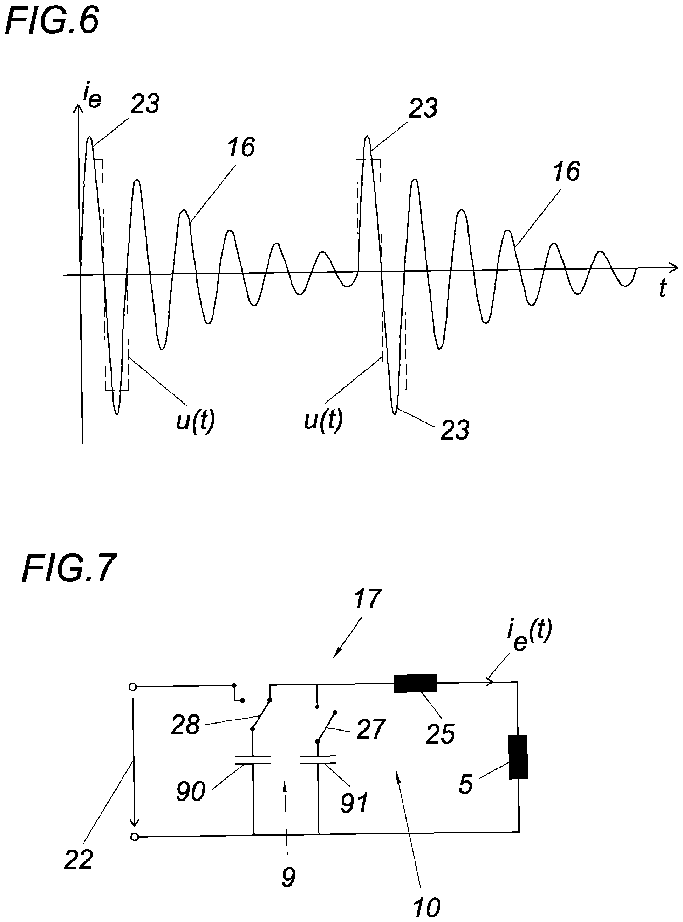

Beispielsweise wird ein Schwingkreis 10 zu einer freien Schwingung 16 mit der Resonanzfrequenz $fres = 1/\sqrt{LC}$ des Schwingkreises 10 angeregt, wie solche eine Schwingung 16 nach Fig. 4 zu erkennen ist. Diese erfährt durch Schwingung 16 durch nicht näher dargestellte elektrische Widerstände eine Dämpfung. Zur Realisierung diese Anregung wird auf eine Erregereinrichtung 17 der Fig. 7 verwiesen, die eine alternative Ausführung zur nach Fig. 1 dargestellten Erregereinrichtung 7 darstellt, wodurch ein zweites Ausführungsbeispiel ausbildet wird. So ist der Fig. 7 eine über einen Wechselschalter 28 zu- und wegschaltbare Spannungsquelle 22 zu entnehmen, die zur Ladung der Kapazität 9 und damit zum Anregen des Schwingkreises 10 zu einer freien gedämpften Schwingung 16 gemäß Fig. 4 verwendet wird.

Alternativ zur Fig. 7 wird in Fig. 5 der Schwingkreis 10 mit einer erzwungenen Schwingung 23 mithilfe der Spannung $u(t)$ angeregt, was zu einem Erregerstrom $i_e(t)$ führt. Vorteilhaft stimmt hier die Anregungsfrequenz $f$ mit der Resonanzfrequenz $fres = 1/\sqrt{LC}$ des Schwingkreises 10 überein. Damit kann die durch Wirkleistung entstehende Dämpfung des Schwingkreises 10 kompensiert und stets ein elektromagnetischer Fluss 12 mit hoher Flussdichte erzeugt werden. Wie hier zu erkennen, kann diese Schwingung 23 die Amplitude trotz Wirkverluste im Schwingkreis halten. Dies erhöht die Genauigkeit des Verfahrens zur Bestimmung der magnetischen Eigenschaft des Blechpakets 3 erheblich.

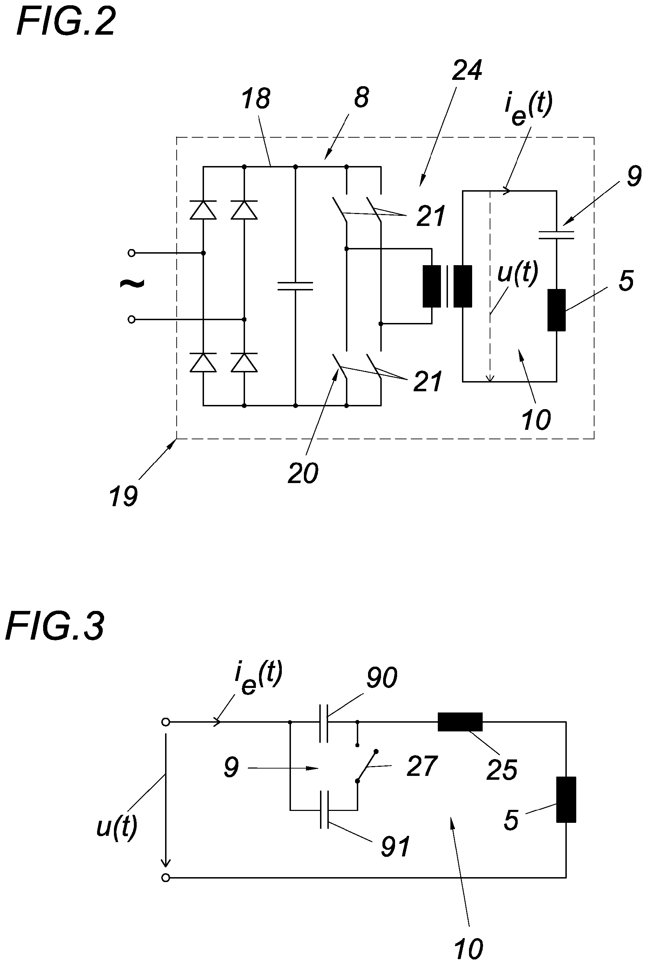

Wird die Anregungsfrequenz $f$ derart lang gewählt, dass sich eine freie gedämpfte Schwingung 16 mit der Resonanzfrequenz $fres = 1/\sqrt{LC}$ einstellt, kann der Schwingkreis 10 auch mit einer Kombination aus zeitweise erzwungener Schwingung 23 und zeitweise frei gedämpfter Schwingung 16 angeregt werden. In Fig. 6 wird dargestellt, den Schwingkreis 10 zeitweise mit einer Anregung $u(t)$ zu beaufschlagen, bevor eine freie Schwingung 16 zugelassen wird. Durch diese vorhergehende Anregung mit einer erzwungenen Schwingung 23 ist zudem die Kapazität 9 für die freie Schwingung 16 ausreichend geladen, was das Verfahren besonders schnell und einfach handhabbar macht. Hierzu kann beispielsweise die nach Fig. 2 dargestellte Erregereinrichtung 24 verwendet werden.

Diese Erregereinrichtung 24 nach Fig. 2 weist außerdem eine besonders robuste Ausführung der elektrischen Quelle zur Leistungsversorgung 8 des Schwingkreises 10 auf. Hier wird ein Wechselrichter 18, der mit dem Schwingkreis 10 einen Schwingkreiswechselrichter 19 ausbildet, verwendet. Der Wechselrichter 18 prägt eine wechselnde Spannung $u(t)$ in den Schwingkreis 10 ein, was zu einem Erregerstrom $i_e(t)$ führt. Zudem wird der Wechselrichter 18 resonant im Sinne eines Nullspannungsschaltens gesteuert, indem bei einem Nulldurchgang der Lastspannung eine Schalteinrichtung 20 die diesbezüglichen Schalter 21 betätigt.

Der nach Fig. 3 näher dargestellte Schwingkreis 10 der Fig. 2 zeigt bei seiner Kapazität 9 ein zu- und wegschaltbares Kapazitätselement 91. Hierzu wird der Schalter 27 betätigt. Es können auch mehrere zu- und wegschaltbare Kapazitäten 91 vorgesehen werden - was nicht näher dargestellt ist. Mit dem zu- und wegschaltbaren Kapazitätselement 91 kann die Resonanzfrequenz $f_{res}$ des Schwingkreises 10 entsprechend der Messanforderung eingestellt werden, weil sich damit die Kapazität 9 je nach Kapazitätselement 90 und Kapazitätselement 91 in der Größe ändern lässt. Damit kann ein erhöhtes Leistungsspektrum des Blechpakets 3 hinsichtlich magnetischer Verluste ausgemessen werden. Eine Bandbreite der Resonanzfrequenz von 50Hz bis 10kHz ist hier vorteilhaft. Mit einer niedrigen Resonanzfrequenz können Hystereseverluste vorwiegend erfasst werden, wobei sich eine dazu höhere Resonanzfrequenz zur vorwiegen Erfassung von Wirbelstromverlusten eignet. Dieselbe Funktion bietet auch der nach Fig. 3 dargestellte Schwingkreis 10.

Die Drossel 25 im Schwingkreis 10 wird zur Verbesserung des Signals $i_e(t)$ verwendet.

Wie nach Fig. 1 zu entnehmen, wird zu der von der als Messspule ausgeführten Messwicklung 6 abgegriffenen Messspannung $u_m(t)$ auch der Erregerstrom $i_e(t)$ zur Messung der magnetischen Eigenschaft des Blechpakets 3 herangezogen. Damit ist es nämlich möglich, die Hysteresekurve 2 darzustellen, um damit die magnetische Eigenschaft des Blechpakets 3 zu bestimmen. Hierzu wird aus der Messspannung $u_m(t)$ der magnetische Fluss über einen Integrator 26 bestimmt, wodurch sich die magnetische Flussdichte B bestimmen lässt. Der Erregerstrom $i_e(t)$ dient zu Bestimmung der magnetischen Feldstärke H, sodass durch Kenntnis von H und B die Hysteresekurve aufgetragen werden kann. Für eine erhöhte Empfindlichkeit wird das Verhältnis des Luftspalts zum effektiven magnetischen Pfad gering gehalten.

Basierend auf den aufgenommenen Messdaten ist es auch möglich, ein mathematisches Modell der Hysteresekurve 2 zu bestimmen, wie in Fig. 1 angedeutet. Die Fläche der Hysteresekurve 2 stellt nämlich ein Maß für die magnetischen Verluste dar. Zur Bestimmung eines mathematischen Modells der Hysteresekurve 2 können verschiedenste Verfahren verwendet werden. Beispielsweise kann hierzu eine Langevin-Funktion dienen, um die Hysterese mathematisch mit einem parametrischen Modell zu beschreiben. Die Parameter für diese Funktion können aus den aktuellen Messdaten bestimmt bzw. daraus geschätzt werden. Im mathematischen Modell wird der Luftspalt als Scherung der Hysteresekurve 2 berücksichtigt, was das Verfahren in der Genauigkeit erhöht. Ein Vergleich zwischen Referenzmessdaten an einem nicht näher dargestellten Referenzblechpaket mit den vom Blechpaket 3 unter Test aufgenommenen Messdaten kann diese Genauigkeit weiter erhöhen. Hierzu kann eine nicht näher dargestellte Messbrücke verwendet werden.

## Patentansprüche

1. Vorrichtung zur Bestimmung der magnetischen Eigenschaft eines Blechpakets (3) mit einem ferromagnetischen Kern (4), mit einer Erregereinrichtung (7, 17, 24), die eine Leistungsversorgung (8) und einen von der Leistungsversorgung (8) angeregten elektrischen Schwingkreis (10) aufweist, der eine Kapazität (9) und eine mit der Kapazität (9) elektrisch verbundene, am Kern (4) vorgesehene Erregerwicklung (5) umfasst, welche Erregerwicklung (5) dazu eingerichtet ist einen magnetischen Fluss (12) im Kern (4) für einen magnetischen Kreis (13) zu erzeugen und mit einer Messeinrichtung (14), die eine am Kern (4) vorgesehene, mit der Erregerwicklung (5) magnetisch gekoppelte Messwicklung (6) aufweist, wobei die Leistungsversorgung (8) dazu eingerichtet ist den Schwingkreis (10) zu einer Schwingung (23) mit der Resonanzfrequenz ($f_{res}$) des Schwingkreises (10) anzuregen, **dadurch gekennzeichnet, dass** die Leistungsversorgung (8) einen Wechselrichter (18) aufweist, der mit dem Schwingkreis (10) der Erregereinrichtung (7) einen Schwingkreiswechselrichter (19) ausbildet.

2. Vorrichtung nach Anspruch 1, **dadurch gekennzeichnet, dass** die Leistungsversorgung (8) den Schwingkreis (10) zu einer freien Schwingung (16) anregt.

3. Vorrichtung nach Anspruch 1, **dadurch gekennzeichnet, dass** die Leistungsversorgung (8) den Schwingkreis (10) entweder zu einer erzwungenen Schwingung (23) oder zu einer zeitweise freien und zeitweise erzwungenen Schwingung (16, 23) anregt.

4. Vorrichtung nach Anspruch 3, **dadurch gekennzeichnet, dass** die Anregungsfrequenz (f) der Leistungsversorgung (8) mit der Resonanzfrequenz ($f_{res}$) des Schwingkreises (10) übereinstimmt.

5. Vorrichtung nach einem der Ansprüche 1 bis 4, **dadurch gekennzeichnet, dass** der Schwingkreiswechselrichter (19) eine Schalteinrichtung (20) aufweist, die den Wechselrichter (18) resonant schaltet.

6. Vorrichtung nach einem der Ansprüche 1 bis 5, dass der Schwingkreis (10) eine Drossel (25) zur Signalverbesserung aufweist.

7. Vorrichtung nach einem der Ansprüche 1 bis 6, dass der Schwingkreis (10) zur Veränderung dessen Resonanzfrequenz ($f_{res}$) mindestens eine in der Größe veränderbare Kapazität (9) aufweist.

8. Vorrichtung nach Anspruch 7, dass der Schwingkreis (10) ein über einen Schalter (27) zu- und wegschaltbares Kapazitätselement (91) aufweist.

9. Verfahren zur Bestimmung der magnetischen Eigenschaft eines Blechpakets (3), bei dem ein elektromagnetischer Fluss (12) von einer an einem Kern (4) vorgesehenen Erregerwicklung (5) erzeugt wird, indem ein Schwingkreis (10), umfassend die Erregerwicklung (5) und eine Kapazität (9), von einer Leistungsversorgung (8) zu einer Schwingung (16, 23) angeregt wird, der erzeugte magnetische Fluss (12) einen magnetischen Kreis (13) über das Blechpaket (3) und den Kern (4) ausbildet und mit Hilfe einer mit der Erregerwicklung (5) magnetisch gekoppelten Messwicklung (6) Messdaten aufgenommen und anhand wenigstens dieser Messdaten die magnetische Eigenschaft des Blechpakets (3) bestimmt wird, **dadurch gekennzeichnet, dass** der Schwingkreis (10) zur Erzeugung des elektromagnetischen Flusses (12) zu einer Schwingung (23) mit seiner Resonanzfrequenz (fres) angeregt wird, wofür die Leistungsversorgung (8) einen Wechselrichter (18) aufweist, der mit dem Schwingkreis (10) der Erregereinrichtung (7) einen Schwingkreiswechselrichter (19) ausbildet.

10. Verfahren nach Anspruch 9, **dadurch gekennzeichnet, dass** der Schwingkreis (10) zu einer freien Schwingung (16) anregt wird.

11. Verfahren nach Anspruch 9, **dadurch gekennzeichnet, dass** der Schwingkreis (10) entweder zu einer erzwungenen Schwingung (23) oder zu einer zeitweise freien und zeitweise erzwungenen Schwingung (16, 23) angeregt wird.

12. Verfahren nach Anspruch 11, **dadurch gekennzeichnet, dass** die Anregungsfrequenz (f) und die Resonanzfrequenz ($f_{res}$) des Schwingkreises (10) gleich sind.

13. Verfahren nach einem der Ansprüche 9 bis 12, **dadurch gekennzeichnet, dass** bei der Bestimmung der magnetischen Eigenschaft des Blechpakets (3) die Resonanzfrequenz ($f_{res}$) des Schwingkreises (10), insbesondere über die Größe der Kapazität (9), verändert wird.

14. Verfahren nach Anspruch 13, **dadurch gekennzeichnet, dass** bei der magnetischen Eigenschaft des Blechpakets (3) zwischen Wirbelstromverlusten und Hystereseverlusten unterschieden wird, in dem der Schwingkreis (10) nacheinander mit zwei unterschiedlichen Resonanzfrequenzen ($f_{res}$) betrieben wird.

15. Verfahren nach einem der Ansprüche 9 bis 14, **dadurch gekennzeichnet, dass** basierend auf den aufgenommenen Messdaten ein mathematisches Modell der Hysteresekurve (2) bestimmt wird, die bei der Bestimmung der magnetischen Eigenschaft des Blechpakets (3) berücksichtigt wird.

16. Verfahren nach Anspruch 15, **dadurch gekennzeichnet, dass** im mathematischen Modell der Luftspalt als Scherung der Hysteresekurve (2) berücksichtigt wird.

17. Verfahren nach einem der Ansprüche 9 bis 16, **dadurch gekennzeichnet, dass** bei der Bestimmung der magnetischen Eigenschaften des Blechpakets (3) ein Vergleich zwischen Referenzmessdaten an einem Referenzblechpaket mit den aufgenommenen Messdaten eingeht.

18. Verfahren nach einem der Ansprüche 9 bis 17, **dadurch gekennzeichnet, dass** der Schwingkreiswechselrichter (19) eine Schalteinrichtung (20) aufweist, die den Wechselrichter (18) resonant schaltet.

**Claims**

1. An apparatus for determining the magnetic properties of a lamination stack (3) having a ferromagnetic core (4), comprising an excitation device (7, 17, 24) which comprises a power supply unit (8) and an electrical resonant circuit (10) excited by the power supply unit (8), said resonant circuit comprising a capacitor (9) and an excitation winding (5) which is electrically connected to the capacitor (9) and is provided on the core (4), and which excitation winding (5) is to generate a magnetic flux (12) in the core (4) for a magnetic circuit (13), and comprising a measuring device (14) which has a measuring winding (6) provided on the core (4) and magnetically coupled to the excitation winding (5), wherein the power supply unit (8) is formed to excite the resonant circuit (10) to an oscillation (23) at the resonant frequency ($f_{res}$) of the resonant circuit (10), **characterized in that** the power supply unit (8) comprises an inverter (18) which forms a resonant-circuit inverter (19) with the resonant circuit (10) of the excitation device (7).

2. An apparatus according to claim 1, **characterized in that** the power supply unit (8) excites the resonant circuit (10) to a free oscillation (16).

3. An apparatus according to claim 1, **characterized in that** the power supply unit (8) excites the excitation circuit (10) either to a forced oscillation (23) or to an intermittent free and intermittent forced oscillation (16, 23).

4. An apparatus according to claim 3, **characterized in that** the excitation frequency (f) of the power supply unit (8) matches the resonant frequency ($f_{res}$) of the oscillation circuit (10).

5. An apparatus according to one of the claims 1 to 4, **characterized in that** the resonant-circuit inverter (19) comprises a switching device (20) which resonantly switches the inverter (18).

6. An apparatus according to one of the claims 1 to 5, **characterized in that** the resonant circuit (10) comprises an inductor (25) for improving the signal.

7. An apparatus according to one of the claims 1 to 6, **characterized in that** the resonant circuit (10), for changing its resonant frequency ($f_{res}$), comprises at least one capacitor (9) which is variable in its magnitude.

8. An apparatus according to claim 7, **characterized in that** the resonant circuit (10) comprises a capacitor element (91) which can be connected and disconnected via a switch (27).

**9.** A method for determining the magnetic properties of a lamination stack (3), in which an electromagnetic flux (12) is generated by an excitation winding (5) provided on a core (4), in that a resonant circuit (10), comprising the excitation winding (5) and a capacitor (9), is excited by a power supply unit (8) to an oscillation (16, 23), the generated magnetic flux (12) forms a magnetic circuit (13) via the lamination stack (3) and the core (4), and measurement data is recorded by means of a measuring winding (6) which is magnetically coupled to the excitation winding (5), and the magnetic properties of the lamination stack (3) are determined by means of at least these measurement data, **characterized in that** for generating the electromagnetic flux (12) the resonant circuit (10) is excited to an oscillation (23) with its resonant frequency ($f_{res}$), for which purpose the power supply unit (8) comprises an inverter (18) which forms a resonant-circuit inverter (19) with the resonant circuit (10) of the excitation device (7).

**10.** A method according to claim 9, **characterized in that** the resonant circuit (10) is excited to a free oscillation (16).

**11.** A method according to claim 9, **characterized in that** the resonant circuit (10) is excited either to a forced oscillation (23) or to an intermittent free and intermittent forced oscillation (16, 23).

**12.** A method according to claim 11, **characterized in that** the excitation frequency (f) and the resonant frequency ($f_{res}$) of the resonant circuit (10) are equal.

**13.** A method according to one of the claims 9 to 12, **characterized in that** in the determination of the magnetic properties of the lamination stack (3) the resonant frequency ($f_{res}$) of the resonant circuit (10) is varied, especially via the magnitude of the capacitor (9).

**14.** A method according to claim 13, **characterized in that** a differentiation is made between eddy current losses and hysteresis losses in the magnetic properties of the lamination stack (3), **in that** the resonant circuit (10) is operated successively with two different resonant frequencies ($f_{res}$).

**15.** A method according to one of the claims 9 to 14, **characterized in that** on the basis of the recorded measurement data a mathematical model of the hysteresis curve (2) is determined, which is considered in the determination of the magnetic properties of the lamination stack (3).

**16.** A method according to claim 15, **characterized in that** the air gap is considered in the mathematical model as a shearing of the hysteresis curve (2).

**17.** A method according to one of the claims 9 to 16, **characterized in that** in the determination of the magnetic properties of the lamination stack (3) a comparison is made between reference measurement data on a reference lamination stack with the recorded measurement data.

**18.** A method according to one of the claims 9 to 17, **characterized in that** the resonant-circuit inverter (19) comprises a switching device (20) which resonantly switches the inverter (18).

**Revendications**

**1.** Dispositif pour déterminer la propriété magnétique d'un paquet de tôles (3) avec un noyau ferromagnétique (4), avec une installation d'excitation (7, 17, 24) qui comprend une alimentation en puissance (8) et un circuit oscillant électrique (10) alimenté par l'alimentation en puissance (8), lequel comprend une capacité (9) et un enroulement d'excitation (5) connecté électriquement à la capacité (9) et prévu sur le noyau (4), lequel enroulement d'excitation (5) est conçu pour produire un flux magnétique (12) dans le noyau (4) pour un circuit magnétique (13), et avec une installation de mesure (14) qui présente un enroulement de mesure (6) prévu sur le noyau (4) et couplé magnétiquement à l'enroulement d'excitation (5), l'alimentation en puissance (8) étant conçue pour exciter le circuit oscillant (10) jusqu'à une oscillation (23) à la fréquence de résonance ($f_{res}$) du circuit oscillant (10), **caractérisé en ce que** l'alimentation en puissance (8) comprend un onduleur (18) qui forme avec le circuit oscillant (10) de l'installation d'excitation (7) un onduleur à circuit oscillant (19).

**2.** Dispositif selon la revendication 1, **caractérisé en ce que** l'alimentation en puissance (8) excite le circuit oscillant (10) jusqu'à une oscillation libre (16).

**3.** Dispositif selon la revendication 1, **caractérisé en ce que** l'alimentation en puissance (8) excite le circuit oscillant (10) soit jusqu'à une oscillation forcée (23), soit jusqu'à une oscillation tantôt libre et tantôt forcée (16, 23).

**4.** Dispositif selon la revendication 3, **caractérisé en ce que** la fréquence d'excitation (f) de l'alimentation en puissance (8) coïncide avec la fréquence de résonance ($f_{res}$) du circuit oscillant (10).

**5.** Dispositif selon l'une des revendications 1 à 4, **caractérisé en ce que** l'onduleur de circuit oscillant (19) présente une installation de commutation (20) qui fait commuter l'onduleur (18) en résonance.

**6.** Dispositif selon l'une des revendications 1 à 5, **ca-**

**ractérisé en ce que** le circuit oscillant (10) comprend une bobine de self (25) pour améliorer le signal.

7. Dispositif selon l'une des revendications 1 à 6, **caractérisé en ce que** le circuit oscillant (10) comprend au moins une capacité (9) de taille variable pour modifier la fréquence de résonance ($f_{res}$).

8. Dispositif selon la revendication 7, **caractérisé en ce que** le circuit oscillant (10) comprend un élément de capacité (91) pouvant être mis en circuit et hors circuit à l'aide d'un commutateur (27).

9. Procédé pour déterminer la propriété magnétique d'un paquet de tôles (3), dans lequel un flux électromagnétique (12) est produit par un enroulement d'excitation (5) prévu sur un noyau (4) par le fait qu'un circuit oscillant (10) comprenant l'enroulement d'excitation (5) et une capacité (9) est excité par une alimentation en puissance (8) jusqu'à une oscillation (16, 23), le flux magnétique (12) produit forme un circuit magnétique (13) passant par le paquet de tôles (3) et le noyau (4) et des données de mesure sont recueillies à l'aide d'un enroulement de mesure (6) en couplage magnétique avec l'enroulement d'excitation (5) et la propriété magnétique du paquet de tôles (3) est déterminée à l'aide au moins de ces données de mesure, **caractérisé en ce que** le circuit oscillant (10) est excité afin de produire le flux électromagnétique (12) jusqu'à une oscillation (23) à sa fréquence de résonance ($f_{res}$), ce pour quoi l'alimentation en puissance (8) comprend un onduleur (18) qui forme avec le circuit oscillant (10) de l'installation d'excitation (7) un onduleur à circuit oscillant (19).

10. Procédé selon la revendication 9, **caractérisé en ce que** le circuit oscillant (10) est excité jusqu'à une oscillation libre (16).

11. Procédé selon la revendication 9, **caractérisé en ce que** le circuit oscillant (10) est excité soit jusqu'à une oscillation forcée (23), soit jusqu'à une oscillation tantôt libre et tantôt forcée (16, 23).

12. Procédé selon la revendication 11, **caractérisé en ce que** la fréquence d'excitation (f) et la fréquence de résonance ($f_{res}$) du circuit oscillant (10) sont les mêmes.

13. Procédé selon l'une des revendications 9 à 12, **caractérisé en ce que** lors de la détermination de la propriété magnétique du paquet de tôles (3), la fréquence de résonance ($f_{res}$) du circuit oscillant (10) est modifiée, en particulier par la taille de la capacité (9).

14. Procédé selon la revendication 13, **caractérisé en ce que** pour la propriété magnétique du paquet de tôles (3), les pertes par courants de Foucault et les pertes par hystérésis sont différenciées en faisant fonctionner le circuit oscillant (10) successivement à deux fréquences de résonance ($f_{res}$) différentes.

15. Procédé selon l'une des revendications 9 à 14, **caractérisé en ce qu'**un modèle mathématique de la courbe d'hystérésis (2) prise en compte pour déterminer la propriété magnétique du paquet de tôles (3) est déterminé sur la base des données recueillies.

16. Procédé selon la revendication 15, **caractérisé en ce que** l'entrefer est pris en compte dans le modèle mathématique comme une transvection de la courbe d'hystérésis (2).

17. Procédé selon l'une des revendications 9 à 16, **caractérisé en ce que** la détermination des propriétés magnétiques du paquet de tôles (3) inclut une comparaison entre les données de mesure de référence d'un paquet de tôles de référence et les données de mesure recueillies.

18. Procédé selon l'une des revendications 9 à 17, **caractérisé en ce que** l'onduleur à circuit oscillant (19) comprend une installation de commutation (20) qui fait commuter l'onduleur (18) en résonance.

FIG.1

EP 2 936 181 B1

## FIG.2

## FIG.3

FIG.4

FIG.5

## FIG.6

## FIG.7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 1773501 A
- JP H11101863 B
- JP H06194436 B
- JP H08278358 B
- WO 2011012159 A
- JP 2006090825 B